# EUROPEAN PATENT SPECIFICATION

(11) **EP 3 052 895 B1**
(45) Date of publication and mention of the grant of the patent: **16.06.2021**
(21) Application number: 14776657.0
(22) Date of filing: 26.09.2014
(51) Int. Cl.: G01D 5/244, G01D 5/347, G01D 11/30, G01R 31/28, H05K 13/00

(54) **METHOD OF MANUFACTURING AN ELECTRONIC COMPONENT**
VERFAHREN ZUR HERSTELLUNG EINER ELEKTRONISCHEN KOMPONENTE
PROCÉDÉ DE FABRICATION D'UN COMPOSANT ÉLECTRONIQUE

(30) Priority: 01.10.2013 EP 13275239
(43) Date of publication of application: 10.08.2016
(73) Proprietor: Renishaw PLC, Wotton-under-Edge, Gloucestershire GL12 8JR (GB)
(72) Inventor: MCADAM, Simon Eliot, Wotton-under-Edge, Gloucestershire GL12 8JR (GB)
(74) Representative: Rolfe, Edward William
(86) International application number: PCT/EP2014/070621
(87) International publication number: WO 2015/049175

(56) References cited:
- JP-A- 2009 257 771
- JP-U- H0 385 523
- US-A- 4 593 820
- US-A1- 2004 261 283
- US-A1- 2005 218 313
- US-A1- 2012 206 024

## Description

The present invention relates to a method of manufacturing an electrical component, in particular a printed circuit board, such as a printed circuit board for a measurement device, such as a position measurement encoder apparatus.

Position measurement encoders are known wherein the scale comprises a series of generally periodic features which the readhead can read to determine and measure relative motion. Various types of position measurement encoder exist, including incremental encoders and absolute encoders. Also, position measurement encoders can utilise various means of reading a scale, including optical, magnetic, capacitive and/or inductive (a position measurement encoder can utilise more than one such means for reading a scale).

Typically, optical incremental encoders operate by the scale (and often one or more diffraction gratings within the readhead) interacting with light from a source within the readhead to generate at a detector a resultant field (e.g. modulated spot(s) or interference fringes) which changes with relative movement of the scale and readhead. Often, but not necessarily, one or more reference marks are provided (e.g. embedded within or next to the series of features) such that relative position can be determined with respect to known reference positions defined by the reference marks. An example of an optical incremental encoder is described in WO2005/124282.

Typically, absolute encoders operate by the scale defining unique patterns (e.g. codes) which can be read by a readhead. Examples of absolute encoders are described in WO2002/084223 and WO2010/049682.

It can be important when manufacturing electrical devices, such as encoders for example, to locate the position of one or more components that make up the electrical device precisely in order to achieve good functionality.

US2012/0206024 discloses a servo motor manufacturing method, which includes a disk position adjusting that adjusts a position of a rotating disk with respect to a shaft. In a case where the rotating disk to which at least one concentric pattern is formed around a disk center is to be fixed to said shaft of a motor, the concentric pattern is used as a scale of a linear encoder to adjust an eccentricity of the rotating disk.

US2004/0261283 discloses a modular scanning unit for a position measuring system and including a support having a recess with a guide surface and a holder adjustably supported upon the support, wherein the holder has a light source and a beam-shaping device aligned with the light source. The holder is also embodied for adjusting the angular position in relation to the scale by being rotatable in the recess in all directions. The adjustment of the holder in the recess of the support takes place in particular in that the holder has engagement surfaces for an adjusting tool, which are engaged by the tool. The adjusting tool is, in particular, a manipulator (robot), controlled as a function of the instantaneous scanning signals from a detector unit, which encloses the holder at the engagement surfaces. JPH0385523U discloses positioning a photodetector array on a substrate.

This application describes a method of manufacturing an electrical device in which an electrical connection is made to a component of the electrical device during said manufacture.

According to the invention there is provided a method of manufacturing an measurement device as defined in claim 1, said device comprising a readhead for an optical position measurement encoder apparatus, the readhead, comprising at least one sensor, the sensor comprising at least one photodetector, the method comprising: positioning at least one component of the readhead and the at least one sensor with respect to each other using the output from the at least one sensor, which comprises tweaking the relative location of the at least one sensor and the at least one component using the output from the sensor, the at least one component comprising an optical component, wherein the method comprises a manufacturing apparatus comprising an actuator holding and moving the at least one sensor and a processor device using the output from the sensor to control the motion of the actuator so as to position the at least one sensor.

Accordingly the output from the sensor can be used in the process of positioning the sensor and at least one component relate to each other (e.g. used to help determine a preferred/optimum positioning of the sensor / at least one component). Using the output from the sensor to aid positioning the sensor and at least one component relative to each other can improve the quality of the electronic device. It can aid preferred/optimum positioning of the sensor and component with respect to each other, which can be useful in optimising the electronic device, for example in optimising the output from the sensor.

The measurement device can be a metrological device, in particular a device used in the obtaining of dimensional measurements. As will be understood, such a readhead is configured to read a scale. The readhead could be a readhead for an incremental encoder apparatus (e.g. for reading an incremental scale comprising incremental position features) or a readhead for an absolute encoder apparatus (e.g. for reading an absolute scale comprising absolute position features).

The sensor can be a sensor configured to be used during operation of the electronic device. For instance, in the case of the electronic device being a measurement device, the sensor can be that which the measurement device is configured to use to obtain measurements during a measurement process. According to the invention, where a readhead for an encoder apparatus which is configured to detect a scale to determine relative motion between the scale and readhead, the sensor is configured to detect/read the scale.

Accordingly, the sensor can be suitable for reading a scale comprising a series of markings. The output of the sensor can be configured for use in determining the relative position of the readhead and a scale. The method can comprise, placing a calibration artefact such that the sensor can detect the calibration artefact and positioning the at least one component (e.g. the sensor - see below) using output from the sensor (e.g. tweaking the relative location of the sensor and/or the at least one component using the output from the sensor). The calibration artefact could be a piece of scale.

The method comprises positioning the sensor using the output from the sensor.

The electronic device is an optical encoder device (e.g. in that it uses optics in its operation, e.g. electromagnetic radiation (EMR) in the infra-red to ultraviolet range). Accordingly, the sensor is an optical sensor (also known as an electro-optical sensor). The sensor comprises at least one photodetector, for example a plurality of photodetectors, for instance an array of photodetectors. As explained in more detail below, the sensor can comprise an array of photodetectors for detecting an interference fringe. The sensor can comprise two or more sets of interdigitated/interlaced photodetectors, each set configured to detect a different phase of an interference fringe.

The at least one component is an optical component configured to interact with optical radiation before the optical radiation reaches the sensor. Hereinafter, optical radiation is referred to as "light", and as will be understood comprises EMR in the infra-red to ultraviolet range. The optical component can comprise a lens. For example, the lens could be configured to focus light onto one or more spots on the sensor. Optionally, the lens could be used to produce an image of an object (e.g. a scale) on the sensor. The optical component can comprise a diffraction grating. The diffraction grating could be used to form a resultant field on the sensor which changes with movement of the electronic device relative to an external object (e.g. a scale). For example, the resultant field could comprise an interference fringe which changes/moves with relative movement of the electronic device and the object/scale. For example, the resultant field could comprise a light spot which modulates between relative dark and bright with relative movement of the electronic device and the object/scale. Examples of other types of optical component include (but not limited to) mirrors, prisms, zone plates (e.g. Fresnel zone plate), and beam splitters).

The at least one component is an optical component (e.g. an optical component for interacting with optical radiation before the light reaches the sensor).

The output from the sensor could be used by an operator, i.e. a human operator, in order to aid positioning the at least one component. For instance, a device could provide a visual indication (e.g. display on a screen) of information (e.g. a graphical representation) which is dependent on the output and which the user can use to tweak the position of the at least one component.

The method comprises a manufacturing apparatus comprising an actuator holding and moving the at least one component. The method further comprises a processor device controlling the motion of the actuator so as to position the at least one component based on the output from the sensor. The method comprises a processor device controlling the motion of the actuator so to tweak the position of the at least one component based on the output from the sensor. The method can comprise analysing the output from the sensor at at least one particular position and/or orientation of the at least one component. The method can further comprise adjusting the position of the at least one component based on (e.g. the result/outcome of) such analysis. The method can comprise monitoring the output from the sensor for a series of different test configurations.

The output can comprise a signal, for example an analogue or digital signal. The method can comprise using the raw signal output from the sensor. Optionally, the method comprises using a processed version of a signal output from the sensor. Optionally, software and/or electronics (e.g. a processor device) is configured to process the output from the sensor to provide data which can be used to determine how to position the at least one component. Such software and/or electronics (e.g. a processor device) can be provided as part of and/or separately to the measurement device. Accordingly, the decision on how to position the at least one component can be based on the direct output from the sensor, or on a signal/data obtained by processing the direct output from the sensor. In either case, as will be understood, the output from the sensor is used in the positioning of the at least one component. In other words, the positioning of the at least one component is dependent on the output from the sensor.

The manufacturing apparatus could communicate with the sensor wirelessly. The manufacturing apparatus can comprise at least one electrical connector for electrically connecting to the at least one component (e.g. the sensor) when it is held by the actuator. When the at least one component is not the sensor, but another electrical component, then it might be useful to provide an electrical connection, e.g. so as to supply power and/or so as to install and/or retrieve data). As will be understood, the at least one electrical connector need not physically connect directly to the sensor. Rather, for example, the sensor could be mounted on another component (e.g. a printed circuit board (PCB)) and the at least one electrical connector can be configured to physically connect to a contact on the other component (e.g. on the PCB).

The actuator can comprise the at least one electrical connector.

The actuator can comprise at least one gripper, for example a plurality of grippers, for engaging the at least one component, in particular so as to facilitate the holding of the at least one component. In the case in which the at least one component is a PCB (e.g. a PCB on which the sensor is mounted), the at least one gripper can be biased laterally across the PCB. For example, the at least one gripper can be biased parallel to the plane of the PCB. The at least one gripper can be biased against a surface extending between the faces of the printed circuit. The at least one gripper can be biased against the peripheral edge of the PCB.

Said at least one gripper can comprise the above mentioned at least one electrical connector. Accordingly, in other words, at least one gripper can comprise one or more electrical connectors. As will be understood, the actuator could comprise at least one gripper which comprises at least one electrical connector and at least one gripper which does not comprise an electrical connector.

Optionally, at least one electrical connector is provided separately to the gripper (which could optionally itself comprise at least one electrical connector). In this case, optionally, the at least one gripper and at least one electrical connector are biased laterally across the PCB. For example, the at least one gripper and at least one electrical connector are biased parallel to the plane of the PCB.

The at least one gripper and at least one electrical contact can be biased against a surface extending between the faces of the PCB. The at least one gripper and at least one electrical connector can be biased against the peripheral edge of the PCB.

The peripheral edge of the PCB can comprises at least one recess in which the at least one gripper and/or at least one electrical connector are received. Accordingly, this can be such that they sit at least flushly with, and optionally within, the predominant outer perimeter defined by the PCB.

A plurality of electrical connectors can be provided for connecting to the at least one component (e.g. the at least one sensor). For example, one or more electrical connectors can be used to supply electrical power to the sensor (and optionally any other associated components). For example, one or more electrical connectors can be used to supply electrical power to a PCB on which the sensor is provided (and optionally any other associated components). For example, one or more electrical connectors can be used to facilitate communication with the sensor (and optionally any other associated components). For example, one or more electrical connectors can be used to facilitate communication with the sensor (and optionally any other associated components).

Data can be transferred between the printed circuit board and a processor device via the electrical connection. Data can be transferred to and/or from a memory device on the printed circuit board via the electrical connection.

As mentioned above, the sensor can be mounted on a PCB. The at least one gripper and at least one electrical connector can be biased against the PCB in the same direction. The at least one gripper and at least one electrical connector can be biased laterally across the PCB. The at least one gripper and at least one electrical connector can be biased against a surface extending between the planar faces of the PCB. The at least one gripper and at least one electrical connector can be biased against the peripheral edge of the PCB.

The measurement device comprises a readhead for an encoder apparatus. The sensor is suitable for reading a scale comprising a series of markings. The output from the sensor can be configured for use in determining the relative position of the readhead and a scale. The method can comprise placing a calibration artefact such that the sensor can detect the calibration artefact.

Accordingly, this application describes, a method of manufacture comprising a manufacturing apparatus comprising an actuator comprising at least one gripper picking up a printed circuit board ("PCB") and locating it with respect to another component at preferred position, the apparatus comprising at least one electrical connector for electrically connecting to the PCB when it is picked up by the actuator, the at least one gripper and at least one electrical connector being biased against the PCB in the same dimension.

The at least one gripper can provide at least one electrical connector. Electrical power can be supplied to the printed circuit board via the electrical connection.

The PCB can comprise at least one sensor, the output of which is supplied to a processor via the at least one electrical connector. The processor can control the motion of the actuator, and hence the position of the PCB relative to the other component, based on the output from the least one sensor. The processor can control the position of the PCB with respect to a housing to which the printed circuit board is to be secured. The sensor can comprises a photodetector array, the housing can comprises a diffraction grating which interacts with electromagnetic radiation ("EMR") to produce a resultant field on the sensor. The resultant field can be an interference fringe which moves with relative movement between the sensor and diffraction grating. The method can comprising placing a scale comprising a series of periodic markings defining an incremental scale track such that light interacts with the scale and the diffraction grating to produce the resultant field on the sensor.

The method can comprise releasing the PCB from the actuator. The method can comprise securing the PCB to the other component prior to releasing the actuator from the PCB. Releasing the PCB from the actuator can comprise releasing the bias of the at least one electrical connector against the PCB before releasing the bias of the at least one gripper against the PCB.

This application also describes, a method of manufacturing a sensor device (e.g. an encoder readhead), the sensor device comprising at least one sensor component (e.g. a photodiode), in which the method comprises reading data out from the sensor component during the manufacturing process and using said data to aid the manufacturing process.

This application also describes a method of manufacturing an electrical device comprising a manufacturing apparatus comprising an actuator for holding and moving an electronic component (e.g. so as to locate it with respect to another component of the electrical device), the manufacturing apparatus electrically connecting to the electronic component via at least one electrical connector when it is held (and for example) moved by the actuator.

Optionally, electrical power is supplied to the electronic component via the at least one electrical connector. Optionally, information is transferred between the electronic component and a processor device via the electrical connection. Such information can take the form of analogue or digital signals. Measurement data or other types of data (e.g. configuration and/or setup) can be transferred via the at least one electrical connector (e.g. to and/or from the electronic component).

The electrical device can comprise a readhead for an encoder apparatus. The electronic component can comprise a sensor configured to read a scale comprising a series of markings the output of which is configured for use in determining the relative position of the readhead and a scale. The method can comprise connecting to said sensor and reading signals from said sensor.

This application also describes a readhead for an encoder apparatus, comprising a PCB comprising a sensor for detecting a scale, and at least one electrical connector provided on its surface extending between its faces which provide for electrical connection to the sensor.

This application also describes, a method of manufacture comprising a manufacturing apparatus comprising an actuator picking up a printed circuit board and in which an electrical connection to the printed circuit board is provided via at least one apparatus contact which is biased laterally onto a corresponding board contact on said printed circuit board.

The manufacturing apparatus can electrically connect to the printed circuit board via a plurality of apparatus contacts, each of which are biased laterally onto corresponding board contacts on said printed circuit board.

Embodiments of the invention will now be described, by way of example only, with reference to the following drawings in which:
Figure 1 is a schematic drawing of an electrical device, in particular a readhead for a position measurement encoder, made according to the method of the invention;
Figures 2a and 2b are top and bottom exploded views of the readhead of Figure 1;
Figures 3 and 4 are schematic ray diagrams schematically illustrating the generation of a resultant field at the incremental photodetector via the use of diffracted light so as to facilitate incremental reading of the readhead position;
Figure 5 is a schematic drawing of one type of incremental detector suitable for use in a readhead according to the invention;
Figure 6a to 6d illustrate an apparatus for gripping and locating a printed circuit board (PCB) of the readhead of Figures 1 and 2 within a body of the readhead;
Figure 7 provides an upper perspective view of the apparatus of Figure 6;
Figures 8a and 8b are top and bottom perspective views of the grippers and electrical contacts of the apparatus of Figure 6 as they engage the PCB;
Figures 9a and 9b are top and bottom views of the apparatus of Figure 6;
Figure 10 illustrates a flow chart according to the invention; and
Figure 11 schematically illustrates the difference in length of the electrical contacts and the grippers of the apparatus of Figure 6.

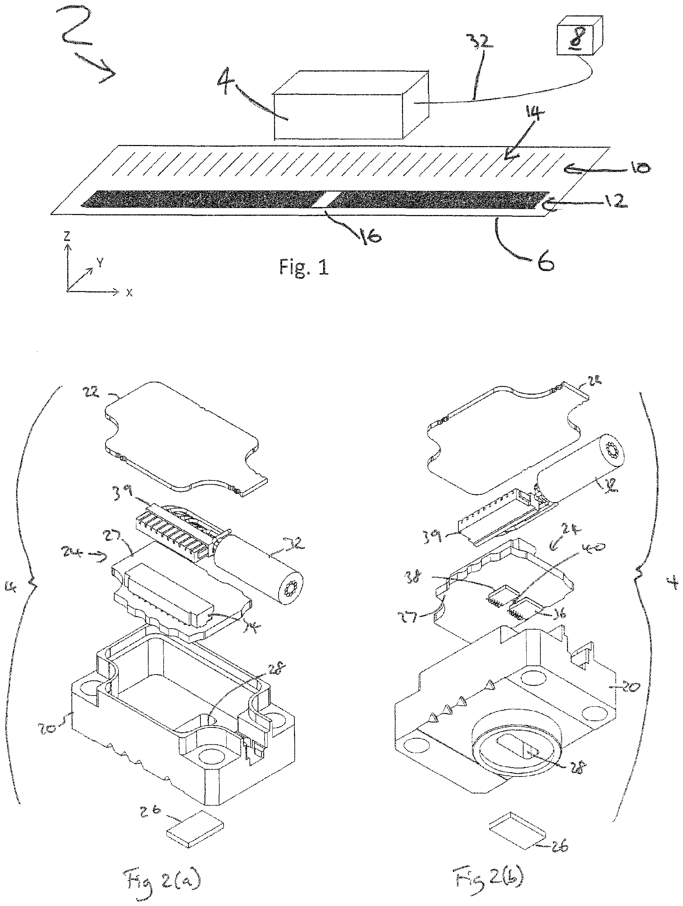

Referring to Figure 1 there is shown a readhead 4 which is part of a position measurement encoder apparatus 2. The position measurement apparatus also comprises a scale 6. Although not shown, typically in practice the readhead 4 will fastened to one part of a machine and the scale 6 to another part of the machine which are movable relative to each other. The readhead 4 is used to measure the relative position of itself and the scale 6 and hence can be used to provide a measure of the relative position of the two movable parts of the machine. In particular, the readhead 4 is configured to read the scale 6 such that their relative position and/or motion can be determined. In this embodiment the position measurement encoder apparatus is an optical encoder, in that the readhead 4 utilises electromagnetic radiation (EMR) in the infra-red to ultraviolet range in order read the scale 6. In particular, and as described in more detail below, the readhead 4 comprises a light source 40 which is used to illuminate the scale 6, and incremental 36 and reference 38 photodetectors in order to detect the scale 6.

Typically, the readhead 4 communicates with a processor such as a controller 8 via a wired (as shown) and/or wireless communication channel. The readhead 4 can report the signals from its detectors (described in more detail below) to the controller 8 which then processes them to determine position information and/or the readhead 4 can itself process the signals from its detectors and send position information to the controller 8.

In the embodiment described, the encoder apparatus 2 is an incremental encoder apparatus and comprises an incremental scale track 10 and a separate reference mark track 12. The incremental track 10 comprises a series of periodic scale marks 14 which control the light reflected toward the readhead 4 to effectively form a diffraction grating. The incremental track 10 could be what is commonly referred to as an amplitude scale or a phase scale. As will be understood, if it is an amplitude scale then the features are configured to control the amplitude of light transmitted toward the readhead's incremental detector (e.g. by selectively absorbing, scattering and/or reflecting the light). As will be understood, if it is a phase scale then the features are configured to control the phase of light transmitted toward the readhead's incremental detector (e.g. by retarding the phase of the light). In the present embodiment, the incremental track 10 is an amplitude scale, but in either case, as explained in more detail below, the light interacts with the periodic scale marks 14 to generate diffracted orders. These diffracted orders then interact with a diffraction grating 26 provided by the readhead 4 (explained in more detail below) which then form a resultant signal on the readhead's incremental detector 36 such that relative motion can be detected and measured.

The reference track 12 comprises a reference position defined by a reference mark 16 which in this case provides a contrast feature compared to the rest of the reference track 12. As will be understood, many other types of reference mark are possible, including reference marks that are embedded within the incremental scale track. Reference positions can be useful to enable the readhead 4 to be able to determine exactly where it is relative to the scale 6. Accordingly, the incremental position can be counted from the reference position. Furthermore, such reference positions can be what are also referred to as "limit positions" in that they can be used to define the limits or ends of the scale 6 between which the readhead 4 is permitted to travel.

Referring to Figures 2a and 2b, the readhead 4 comprises a body 20, a lid 22, a printed circuit board (PCB) assembly 24 and a glass plate 26 on part of which a diffraction grating is formed. Once the readhead 4 has been assembled, the PCB assembly 24 sits within the body 20 and the lid 22 is secured to the body 20 (e.g. via gluing, welding, crimping, or additional mechanical means such as via screws) such that the PCB assembly 24 is contained within the body 20. The PCB assembly 24 comprises a PCB 27, and a cable connector 34, an incremental photodetector 36, a reference mark photodetector 38, a light source 40 and associated processing electronics, mounted on the PCB 27. Furthermore, as shown, the glass plate 26 comprising the diffraction grating is mounted to a window region 28 on the underside of the body, and a cable 32 for carrying signals and power to and from the readhead 4 is connected to the PCB assembly 24 via corresponding connectors 34, 39 on the PCB 27 and cable 32.

With respect to the incremental track 10, light from the source 40 leaves the readhead 4 via a portion of the glass plate 26 that does not contain the diffraction grating and falls on the periodic scale marks 14, which define a diffraction pattern. The light therefore diffracts into multiple orders, which then fall on the part of the glass plate 26 containing the diffraction grating. In the present embodiment, the readhead's diffraction grating is a phase grating. The light is then further diffracted by the readhead's diffraction grating into orders which then interfere at the incremental photodetector 36 to form a resultant field, in this case an interference fringe.

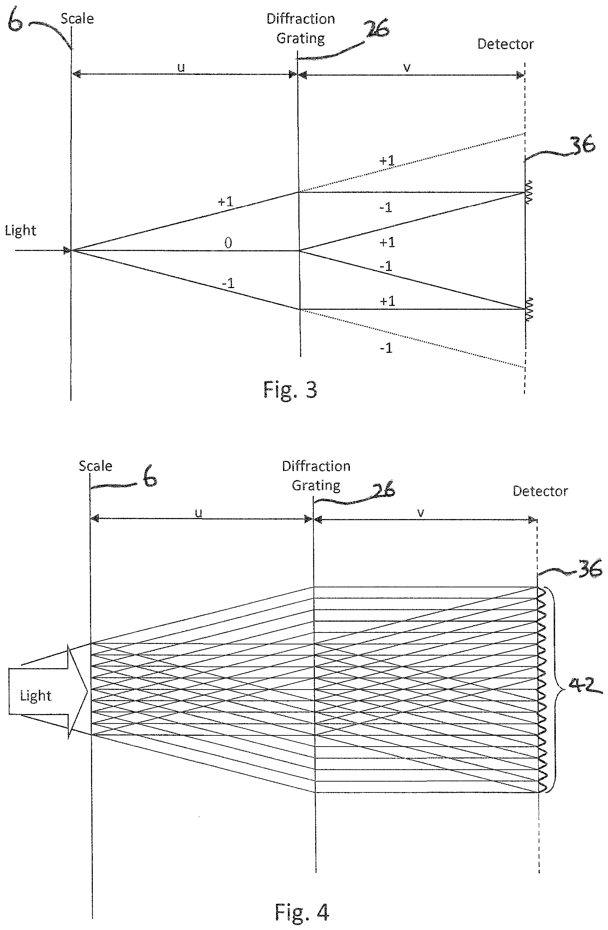

The generation of the interference fringe is explained in more detail with reference to Figures 3 and 4. As will be understood, Figure 3 is a very simplified illustration of the real optical situation encountered in an encoder apparatus. In particular, the situation is shown for only one light ray from the source whereas in fact an area of the incremental track 10 is illuminated by the source. Accordingly, in reality the optical situation shown in Figure 3 is repeated many times over along the length of the scale (i.e. over the area that is illuminated by the source), hence producing a long interference pattern at the detector, which is schematically illustrated in Figure 4. Also, for illustrative purposes only the +/- 1^{st} orders are shown (e.g. as will be understood the light will be diffracted into multiple orders, e.g. +/- 3^{rd}, +/- 5^{th}, etc diffraction orders). The light is diffracted by the series of periodic features 14 in the incremental track 10 of the scale 6, and the diffraction orders propagate toward the diffraction grating on the glass plate 26 where the light is diffracted again before forming a resultant field 42 (in this case an interference fringe, but could for example be modulated spot(s)) at the incremental detector 36. As shown in Figure 4, the resultant field 42 is produced by the recombination of diffracted orders of light from the diffraction grating on the glass plate 26 and scale 6.

The incremental photo detector 36 detects the resultant field 42 (e.g. the interference fringes) to produce a signal which is output by the readhead 4 to an external device such as controller 8 via cable 32. In particular, relative movement of the readhead 4 and scale 6 causes a change in the resultant field (e.g. movement of the interference fringes relative to the detector 36 or a change in intensity of the modulated spot(s)) at the incremental detector 36, the output of which can be processed to provide an incremental up/down count which enables an incremental measurement of displacement.

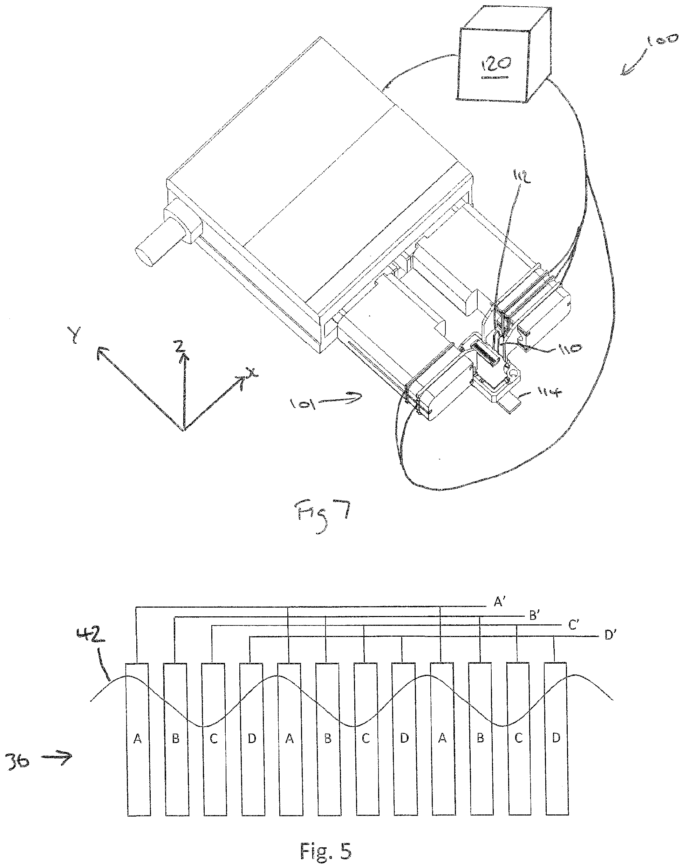

The incremental detector 36 can comprise a plurality of photodiodes, for example. In particular, as will be understood, in embodiments in which an interference fringe 42 is produced at the incremental detector 36, the incremental detector 36 can be in the form of an electro-grating, which in other words is a photo-sensor array which can for example comprise two or more sets of interdigitated/interlaced photo-sensitive sensors, each set detecting a different phase of the interference fringe 42 at the detector 36. An example is illustrated in Figure 5, in which a part of an incremental detector 36 is shown, and in which the photodiodes of four sets of photodiodes A, B, C and D are interdigitated, and the outputs from each photodiode in a set are combined to provide a single output, A', B', C' and D'. As illustrated, at any one instant in time, all the photodiodes in any one set detect the intensity of same phase of the interference fringe (if the fringe period and sensor period are the same). More details of a scale and readhead of this type are described in US5861953, the entire contents of which are incorporated into this specification by this reference. As will be understood, the electrograting/photo-sensor array can take other forms, such as comprising only three sets of photodiodes that are interdigitated, and different layouts can be used.

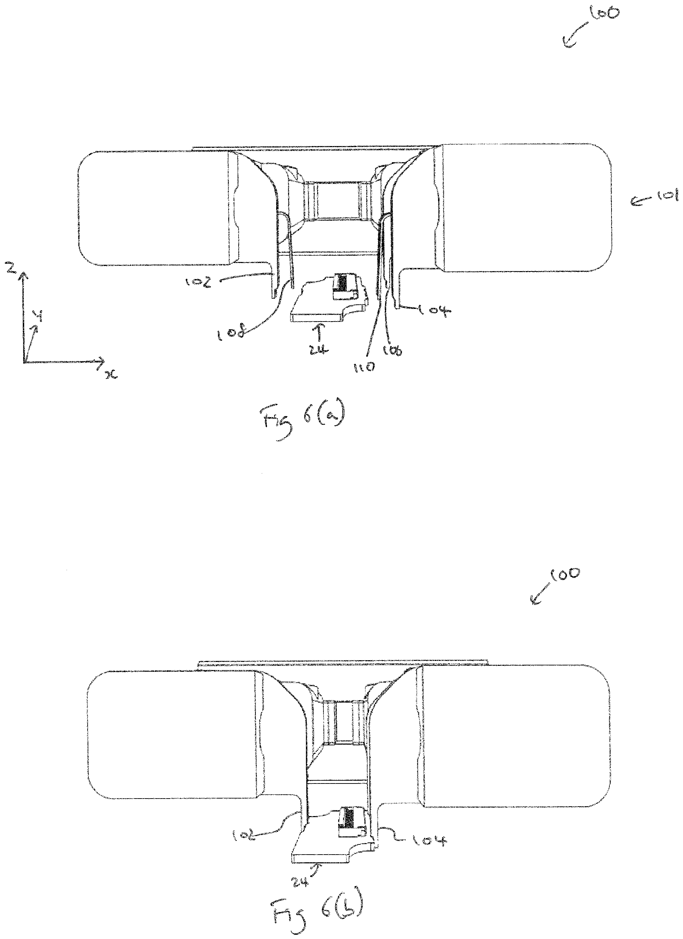

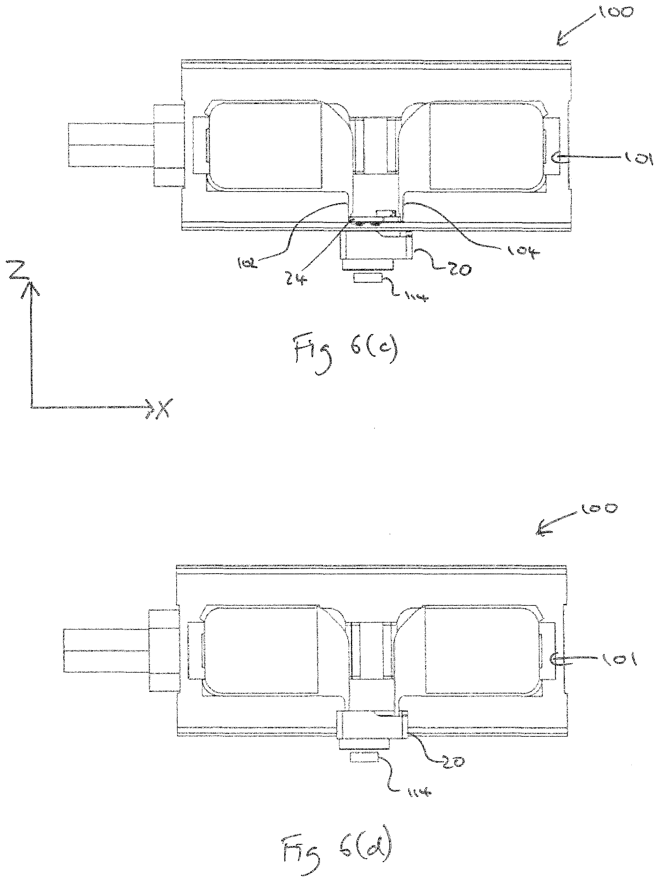

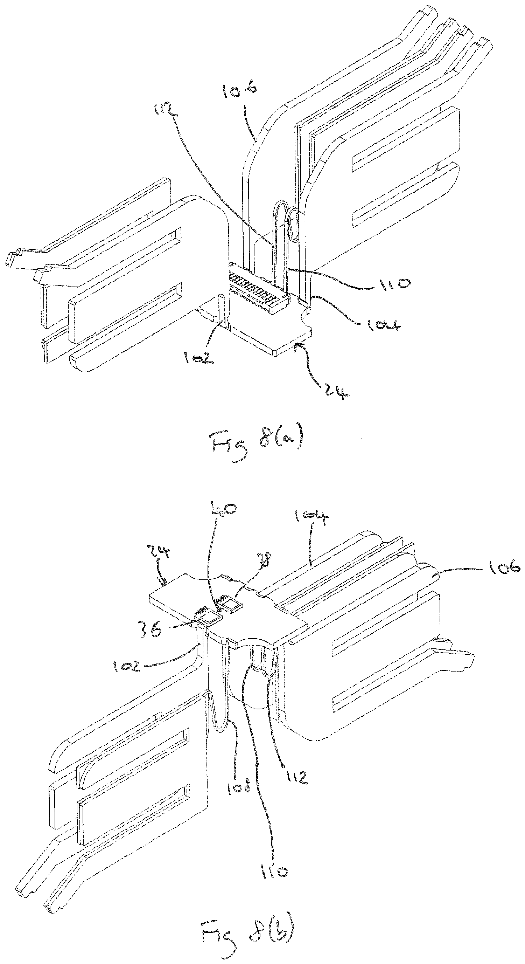

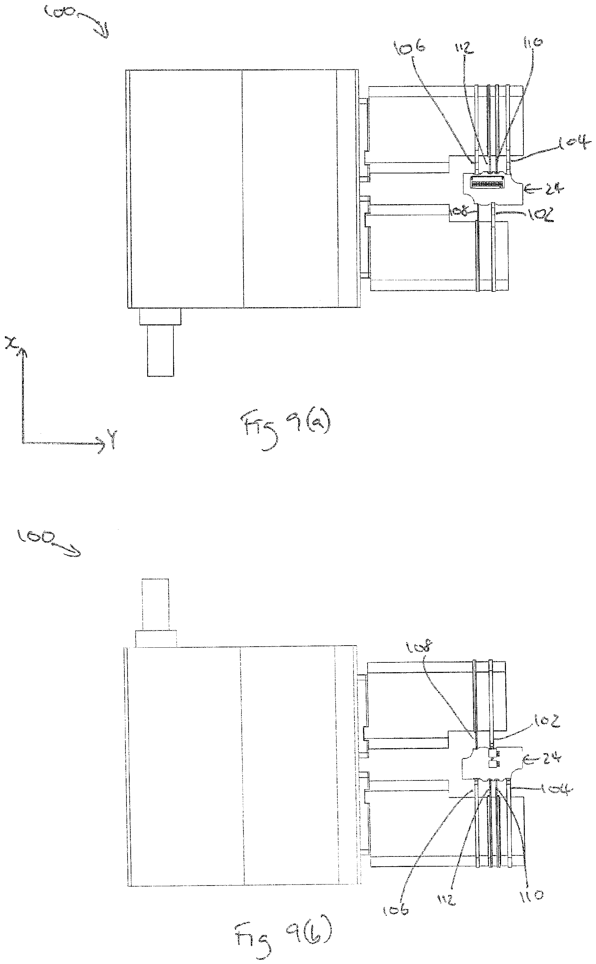

Accordingly, as can be seen from the above it can be important to ensure good alignment between the diffraction grating on the glass plate 26 and the incremental photodetector 36. A method and apparatus for achieving good alignment between these components is described below in connection with Figures 6 to 11.

In summary, the method involves (and the apparatus facilitates) tweaking the position of at least one of the components to be aligned (in this case the PCB assembly 24 with the incremental photodetector 36 on it) whilst monitoring the signal output from the electrical device's sensor that will be used in operation (i.e. in this case monitoring the output from the incremental photodetector 36) so as to achieve a good signal.

Accordingly, referring to Figures 6 to 11, the apparatus comprises a manufacturing apparatus 100 (only part of which is shown for clarity purposes) comprising a manipulator 101 for picking up and moving the PCB assembly 24. The manipulator comprises first 102, second 104 and third 106 grippers configured such that the first gripper 102 can engage one edge of the PCB assembly 24 and such that the second 104 and third 106 grippers can engage the opposite side of the PCB assembly 24. Together, the first 102, second 104 and third 106 can grip the PCB assembly 24 so as to hold and move the PCB assembly 24. The manipulator also comprises first 108, second 110 and third 112 sprung electrical contacts, for engaging corresponding electrical contacts provided on the edge of the PCB assembly 24. In addition to these sprung electrical contacts, electrical contacts are provided by the second 104 and third 106 grippers.

The manufacturing apparatus 100 comprises drives (not shown) for moving the manipulator 101 (and hence a PCB assembly 24 held by the manipulator's grippers 102, 104, 106) in three orthogonal linear dimensions, X, Y and Z. It also includes drives for twisting, the manipulator 101 i.e. rotating it around the Z-axis (optionally, the manufacturing apparatus could comprise drives for moving the manipulator in more than one rotational degree of freedom). In this embodiment, the manufacturing apparatus 100 can control a PCB assembly 27 held in the manipulator 101 so as to twist it (i.e. rotate it) about an axis parallel to the Z-axis. The manufacturing apparatus 100 also comprises drives (not shown) for moving the first 102, second 104 and third 106 grippers and the first 108, second 110 and third 112 sprung electrical contacts so as to selectively engage/release the PCB assembly 24. Furthermore, as will be understood, the manufacturing apparatus 100 comprises position feedback devices (e.g. position measurement encoders) which can be used to determine the position (and orientation) of the manipulator 101 and hence the position (and orientation) of a PCB assembly 27 held by the manipulator 101.

The manufacturing apparatus 100 also comprises a holder (not shown) for the body 20 into which the PCB assembly 24 is to be located, and a stage (not shown) for holding and moving a scale element 114 in the Y and Z dimensions relative to the manipulator 101 (and hence the body 20 and PCB assembly 24). Again, position reporting devices (e.g. position measurement encoders) are provided for reporting the position of the stage (and hence the scale element 114) in the Y and Z dimensions.

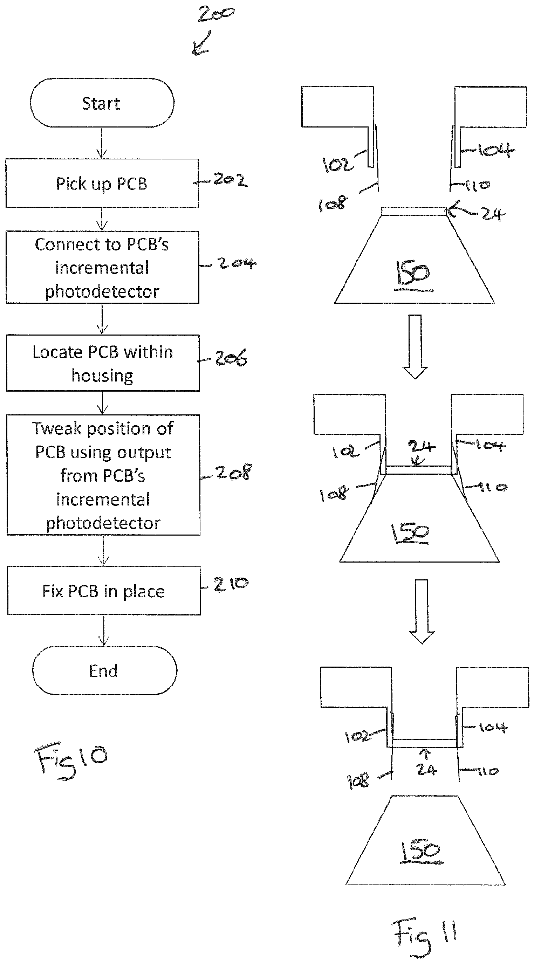

The manufacturing apparatus comprises a processor device (schematically illustrated by reference numeral 120) for transmitting and/or receiving signals to/from the manipulator's electrical contacts (i.e. the first 108, second 110 and third 112 sprung electrical contacts and the electrical contacts provided by the second 104 and third 106 grippers). This can be via a wired or wireless link. The same processor device 120 or a different processor device can also be configured to control the manufacturing apparatus 100, in particular the manipulator 101. Referring to Figure 10, a flow chart illustrating a process 200 according to the invention is shown. The method begins at step 202 at which the processor 120 controls the manipulator 101 to pick up the PCB assembly 24. As illustrated by Figure 6a, this involves positioning the manipulator 101 such that the first 102, second 104 and third 106 grippers, and the first 108, second 110 and third 112 sprung electrical contacts are positioned either side of the PCB assembly 24 (which sits in a storage port (not shown)) and then, as illustrated by Figure 6b, this involves advancing the first 102, second 104 and third 106 grippers, and the first 108, second 110 and third 112 sprung electrical contacts toward the PCB assembly 24 such that they engage the PCB 27. The PCB 27 has electrical contact pads on its circumferential edge which are located so as to engage the second 104 and third 106 grippers and the first 108, second 110 and third 112 sprung electrical contacts. Accordingly, the step 204 of connecting to the PCB assembly's incremental photodetector 36 is achieved at the same time.

In the described example electrical power is supplied to the PCB assembly 24 via the second 104 and third 106 grippers, and the first 108, second 110 and third 112 sprung electrical contacts are signal lines. For example, but not necessarily, one of sprung electrical contacts (e.g. the first sprung electrical contact 108) can be used as a communications line (e.g. to communicate commands to and/or from the PCB assembly 24, and/or to communicate data to/from any memory devices provided as part of the PCB assembly 24), and the other two sprung electrical contacts (e.g. the second 110 and third 112 sprung electrical contacts) can be used to transmit signals from the incremental photodetector 36 to the processor device 120. As will be understood, there can be various other configurations of signal lines. For example, in an embodiment in which the readhead 4 and for example the PCB assembly 24 comprises its own power source (e.g. a battery) electrical contacts for power supply could well be unnecessary. Furthermore, any embodiments in which a communications line is not necessary. Further still, some sensors only provide one signal output, and hence only one signal line would be necessary. Also as will be understood to be within the scope of the invention is an embodiment in which the sensor communicates with a processor device wirelessly, and hence it is possible that no physical electrical contact is necessary.

Referring briefly to Figure 11, as illustrated, the sprung electrical contacts (108, 110, 112) are longer in length than the grippers (102, 104, 106). Furthermore, before the PCB assembly 24 is picked up by the manipulator 101, it sits in a storage port which comprises a trapezoidal seat 150. Accordingly, when the manipulator 101 is brought down over the PCB assembly 24, the sprung electrical contacts are pushed out and away from the PCB assembly by the sloping sides of the trapezoidal seat 150. The manipulator 101 can then bring the opposing grippers together, whilst the trapezoidal seat 150 keeps the sprung electrical contacts away from the PCB 24. As the manipulator 101 lifts the PCB assembly 24 out of its storage port away from the trapezoidal seat 150, the sprung electrical contacts spring back toward their original position, thereby engaging the edges of the PCB assembly 24. Such a configuration avoids the sprung electrical contacts crashing into the PCB assembly 24 on the way to pick the PCB assembly 24 up and also ensures that the grippers have a good hold of the PCB 27 before the sprung electrical contacts exert any force on the PCB 27 (which could otherwise affect the positioning of the PCB assembly 24 within the manipulator 101). As will be understood, there are other ways of ensuring that the sprung electrical contacts 108, 110, 112 do not crash into the PCB assembly 24 and do not contact the PCB 27 until the grippers 102, 104, 106 have a good hold of the PCB 27. For example, the PCB storage port could comprise pockets into which the sprung electrical contacts 108, 110, 112 slide as the manipulator 101 brings the grippers and sprung electrical contacts down towards the PCB assembly 24. The pockets can then hold the sprung electrical contacts 108, 110, 112 back from contacting the PCB 27 until the grippers 102, 104, 106 have a good hold of the PCB 27 and the manipulator 101 lifts the PCB assembly 24 out of the storage port.

As illustrated by Figures 6c and 6d, at step 206, the manipulator 101 moves the PCB assembly 24 so as to locate it within the readhead's body 20. The body 20 is held by the measurement apparatus 100 by a holder (not shown) at a point within the manipulator's 101 movement volume. At this point, the body 20 does not have the lid 22, but it does have the glass plate 26 comprising the diffraction grating mounted within its window region 28. As explained above, and as illustrated in Figures 6c, 6d and 7, a scale element 114 having periodic features which effectively define a diffraction grating (e.g. like that the readhead 4 will see in the incremental track 10 on a scale 6 when in use) is located under the window 28 and hence the glass plate 26 and is mounted on a stage (not shown) which can be driven so as to move the scale element 114 in the Y-dimension and also in the Z-dimension.

At step 208, the position of the PCB assembly 24 is tweaked by the manipulator 101. In summary, this involves powering the PCB assembly 24 via the electrical contacts provided by the second 104 and third 106 grippers such that the light source 40 is activated and illuminates the scale element 114. A resultant field in this case in the form of an interference fringe is then produced on the incremental photodetector 36 in the manner described above in connection with Figures 3 and 4. The incremental photodetector 36 produces signals in response to detection of the interference fringe, which varies with movement of the scale element 114. Such signals are passed to the processor 120 for analysis via the second 110 and third 112 sprung electrical contacts. In summary, a method according to the invention involves the process of the processor 120 receiving signals from the incremental photodetector 36, and analysing the signals whilst the scale element 114 is moved in the Y-dimension. The position of the PCB assembly 24 is tweaked until a desired signal (for example, of desired amplitude) is obtained from the incremental photodetector.

In one particular embodiment the method involves using the output from the incremental photodetector 36 sensor only to aid the positioning/tweaking (e.g. fine tuning) of the PCB assembly 24 in the Z-dimension and also its yaw orientation (i.e. its angular orientation about an axis through the centre of the PCB 27 parallel to the Z-axis). In particular, the method can comprise positioning the PCB assembly 24 at an initial position and orientation within the readhead's body 20. The Z position/height of the PCB assembly 24 in the initial position can be set to be at a height which is expected to be too high. It can be advantageous initially not to place the PCB assembly 24 at what might be expected to be the final desired height in case in fact this is too low and therefore the PCB 27 crashes into the base of the body 20 and/or the PCB 27 causes any pre-applied glue between the PCB 27 and the base of the body 20 (which is ultimately to be used to stick the PCB assembly 24 to the body 20) to be squeezed too thinly.

The method can then involve moving the scale element 114 in the Y-dimension and the processor 120 monitoring the signals from the incremental photodetector 36. The Z position/height of the scale element 114 can then be adjusted, and then again moved in the Y-dimension whilst the processor 120 monitors the signals from the incremental photodetector 36. This can be repeated for a number of different heights of the scale element 114. The incremental photodetector's 36 outputs for the different heights can be analysed to determine how to adjust the height of the PCB assembly 24 relative to the body 20 (e.g. to determine by how much the PCB assembly 24 should be lowered into the body 20) to achieve a good signal at the preferred ride height of the readhead 20 at which it will be ultimately be used. The height of the PCB assembly 24 relative to the body 20 can then be changed by the manipulator 101.

The yaw orientation of the PCB assembly 24 can then be tweaked by moving the scale element 114 along the Y dimension for different yaw orientations of the PCB assembly 24 within the body (which can be effected by the manipulator 101 controlling the yaw orientation) and monitoring the signal from the incremental photodetector 36. The incremental photodetector's 36 outputs for the different yaw orientations can then be analysed to determine at which yaw orientation to set the PCB assembly 24 relative to the body 20.

If desired, the height of the PCB assembly 24 can be checked again by monitoring the output of the incremental photodetector 36 for different Z positions of the scale element 114.

In this embodiment, the X, Y lateral positions and the pitch and roll orientations (angular orientations about axis parallel to the X and Y axes) are not adjusted/tweaked by the method of the invention. Rather they are set by assuming that the manipulator has correctly positioned/orientated the PCB assembly 24 relative to the body 20 in those dimensions/orientations. In the present example, such an assumption can be relied on by that the PCB assembly's 24 general position/orientation in those dimensions/orientations can be determined from knowledge of the position of the manipulator 101 (using feedback from position feedback devices on the manipulator 101/manufacturing apparatus 100) and the body 20 which is held by the measurement apparatus' 100 holder (i.e. in a fixed position). As will be understood, there may be some uncertainty in the exact position at which the PCB assembly 24 is held by the manipulator's grippers 102, 104, 106. If so, a camera could be used to image/view the PCB assembly 24 once it has been picked up by the manipulator 101 such that its X and Y position can be determined. Also, especially if the camera has a relatively narrow depth of field, the camera can provide an approximate Z position of the PCB assembly 24 with respect to the manipulator 101.

Furthermore, in the present example, the accuracy of the type of readhead described is not as sensitive to the placement of the incremental photodetector 36 of the PCB assembly 24 in the X and Y dimensions (nor its pitch and roll orientations) as it is to its placement and orientation in the Z dimension and yaw orientation, and hence tweaking/fine tuning of the PCB in the X and Y positions and the pitch and roll orientations is not as important as the tweaking/fine tuning of the PCB in the Z and yaw degrees of freedom.

As described above, the signal from the incremental photodetector 36 is monitored/analysed. As will be understood, the signal can be analysed as it is output from the incremental photodetector 36. Optionally, the signal can be recorded in memory and analysed at a subsequent point, e.g. after all relevant signals at relative different heights/orientations have been obtained.

As will also be understood, exactly what aspect of the signal(s) that is analysed can depend on the particular various factors including the type of electronic device being manufactured, the type of signal(s) output by the electronic device's sensor and/or exactly how precisely located the sensor or other component needs to be positioned. For example, the method can involve looking at the amplitude of the signal(s).

In the present example, the incremental photodetector 36 outputs two (ideally) generally sinusoidal waves 90° out of phase from each other, commonly referred to as quadrature signals. Such signals can be used to produce a lissajous and one implementation of the signals can be used to determine the radius of the lissajous produced by the incremental photodetector's quadrature signals, and tweak the position and/or orientation in at least one degree of freedom until a radius within a desired tolerance band is achieved.

Once the processor 120 determines that the PCB assembly 24 is in a position at which the signal meets the predetermined criteria, the PCB assembly 24 is fixed in place. This could be achieved for instance via gluing the PCB 27 into place which, for example, can previously have been applied between the PCB 27 and the base of the body 20, and for instance curing UV curable glue by directing UV light at glue between the base of the body 20 and the PCB 27. In order to aid such curing via UV light, holes/windows/UV transmission regions or the like could be provided in the PCB, especially at the regions at which the glue is located, such that UV light can be shone through the PCB so as to cure the glue.

Once the PCB assembly 24 has been secured to the body 20, the processor device 120 controls the manipulator 101 to cause it to retract the grippers 102, 104, 106 and sprung electrical contacts 108, 110, 112 so as to release the PCB assembly 24 from the manipulator 101. The cable 32 can then be connected to the PCB connector 34 and the lid 22 applied to the body 20 (which can be done by the same manufacturing apparatus 100, a different manufacturing apparatus or by a human for example).

In the described embodiment, the grippers and the sprung electrical contacts are biased against the PCB 27 in the same dimension. This ensures that the grippers and sprung electrical contacts do not fight each other which can lead to adverse movement of the PCB 27. Furthermore, the electrical contacts and grippers are biased laterally across the PCB 27, and in particular against an edge extending between the PCB's 27 planar faces. This avoids having to use up valuable space on the planar faces of the PCB 27, and therefore helps keep the size of the PCB 27 to a minimum. However, as will be understood, this need not necessarily be the case. For instance, the manipulator could have electrical contact pins which engage a contact provided on at least one of the planar faces of the PCB 27. Optionally, the grippers could engage the planar faces of the PCB 27.

In the described embodiment, the signal from the incremental photodetector 36 is transferred to the processor device 120 via the electrical contacts provided via the first 108, second 110, third 112 sprung electrical contacts. As will be understood, this need not necessarily be the case. For instance, the PCB assembly 24 could comprise a wireless transmitter for sending the signals to the processor device 120 wirelessly. In this case, power could be supplied to the PCB assembly 24 via electrical contacts provided by the manipulator 101 which engage the PCB. Optionally, the PCB assembly 24 could comprise a battery for powering the PCB assembly 24, including the light source, sensors and any wireless transmitter.

Optionally, data can be transferred between a memory device on the PCB 27 and the processor device 120 (or indeed another processor device). For instance, data (e.g. data for use during the manufacture or use of the readhead) could be loaded into (or indeed extracted from) a memory device on the PCB 27. Examples of types of such data include product serial number, part number, calibration data, built date.

In the embodiment described above, the position of the PCB assembly 24 is manipulated by the manipulator 101. However, as will be understood, just the position of the incremental photodetector 36 could be adjusted and then when the desired position has been found it can be fixed to the PCB 27, which could have previously been mounted to the body. Optionally, the position of the glass plate 26 comprising the index grating could be manipulated instead of or as well as the PCB assembly 24. In all cases, the signal from the incremental photodetector 36 can be used to determine the preferred relative position of the incremental photodetector 36 and the glass plate 26.

In the embodiment described above the position encoder is an incremental encoder. Nevertheless, as will be understood, the invention is also applicable to other types of position encoder, including absolute encoders. For example, many absolute encoders, including those described in WO2010/049682 use a lens to detect an image of the scale. The invention can for example, be useful to aid alignment between the imaging lens and image sensor.

In the embodiments above, the electrical device is a readhead for an optical position measurement encoder apparatus. As will be understood, the invention can also be used to aid the manufacture of other electrical devices such as other types of position measurement encoders, including magnetic and capacitive position measurement encoders. Other examples include other types of sensors, such as temperature sensors, pressure sensors, probes, for example measurement probes, in particular position measurement probes such as the type used on coordinate positioning apparatus such as coordinate measuring machines (CMMs) and machine tools.

Our inventors have also found it to be useful to provide an electrical connection to an electronic component, such as a PCB, whilst its position is being manipulated during manufacture (even if not connecting to a sensor like in the above embodiments). For example, it can be useful to test PCB 27/PCB assembly 24 function before assembly into the final product. It can also be useful to program the electronic component or extract build/test/other data from the electronic component. In particular, when connecting to a PCB, connecting via contacts provided on the edge of the PCB can be advantageous because it can save PCB space, reduce cost and also help avoid deformation of the PCB.

## Claims

1. A method (200) of manufacturing a measurement device comprising a readhead (4) for an optical position measurement encoder apparatus, the readhead comprising at least one sensor (36, 38), the sensor comprising at least one photodetector (36),
**characterized in that** the method comprises:
positioning at least one component (26) of the readhead and the at least one sensor with respect to each other using the output from the at least one sensor, which comprises tweaking (208) the relative location of the at least one sensor and the at least one component using the output from the sensor, the at least one component comprising an optical component, wherein the method comprises a manufacturing apparatus (100) comprising an actuator (101) holding and moving the at least one sensor and a processor device (120) using the output from the sensor to control the motion of the actuator so as to position the at least one sensor.

2. A method as claimed in claim 1, in which the at least one component comprises a lens.

3. A method as claimed in claim 1, in which the at least one component comprises a diffraction grating.

4. A method as claimed in claim 1, the manufacturing apparatus comprising at least one electrical connector (108, 110, 112) for electrically connecting to the sensor when it is held by the actuator.

5. A method as claimed in claim 4, in which the actuator comprises the at least one electrical connector.

6. A method as claimed in claim 5, in which the actuator comprises at least one gripper (102, 104, 106) for engaging the component.

7. A method as claimed in claim 5 and 6, at least one of said at least one gripper comprising said at least one electrical connector

8. A method as claimed in any preceding claim, in which the sensor is mounted on a printed circuit board ("PCB") (24).

9. A method as claimed in claim 6, 7 and 8, in which the at least one gripper and at least one electrical connector are biased against the PCB (24) in the same direction.

10. A method as claimed in claim 9, in which the at least one gripper and at least one electrical connector are biased laterally across the PCB.

11. A method as claimed in any preceding claim, the sensor being suitable for reading a scale (6) comprising a series of markings and the output of which is configured for use in determining the relative position of the readhead and a scale, the method comprising, placing a calibration artefact (114) such that the sensor can detect the calibration artefact and tweaking the relative location of the sensor and/or an optical component using the output from the sensor.

12. A method as claimed in any preceding claim, in which the sensor comprises an array of photodetectors for detecting an interference fringe.

13. A method as claimed in claim 12 in which the sensor comprises two or more sets of interdigitated photodetectors each set configured to detect a different phase of an interference fringe.

## Patentansprüche

1. Verfahren (200) zur Herstellung einer Messvorrichtung mit einem Lesekopf (4) für eine optische Codiervorrichtung zur Positionsmessung, wobei der Lesekopf mindestens einen Sensor (36, 38) umfasst, wobei der Sensor mindestens einen Photodetektor (36) umfasst,
**dadurch gekennzeichnet, dass** das Verfahren umfasst:
Positionieren mindestens einer Komponente (26) des Lesekopfs und des mindestens einen Sensors in Bezug zueinander unter Verwendung des Ausgangs von dem mindestens einen Sensor, der das Optimieren (208) des relativen Orts des mindestens einen Sensors und der mindestens einen Komponente unter Verwendung des Ausgangs von dem Sensor umfasst, wobei die mindestens eine Komponente eine optische Komponente umfasst, wobei das Verfahren eine Herstellvorrichtung (100), die einen Aktor (101) umfasst, der den mindestens einen Sensor hält und bewegt, und eine Prozessorvorrichtung (120) umfasst, die den Ausgang von dem Sensor zur Steuerung der Bewegung des Aktors verwendet, um den mindestens einen Sensor zu positionieren.

2. Verfahren nach Anspruch 1, wobei die mindestens eine Komponente eine Linse umfasst.

3. Verfahren nach Anspruch 1, wobei die mindestens eine Komponente ein Beugungsgitter umfasst.

4. Verfahren nach Anspruch 1, wobei die Herstellvorrichtung mindestens einen elektrischen Verbinder (108, 110, 112) zum elektrischen Verbinden mit dem Sensor umfasst, wenn dieser vom Aktor gehalten wird.

5. Verfahren nach Anspruch 4, bei dem der Aktor den mindestens einen elektrischen Verbinder umfasst.

6. Verfahren nach Anspruch 5, bei dem der Aktor mindestens einen Greifer (102, 104, 106) zum Eingriff mit der Komponente umfasst.

7. Verfahren nach Anspruch 5 und 6, wobei mindestens einer der mindestens einen Greifer den mindestens einen elektrischen Verbinder umfasst.

8. Verfahren nach einem der vorhergehenden Ansprüche, wobei der Sensor auf einer Leiterplatte ("PCB") (24) montiert ist.

9. Verfahren nach Anspruch 6, 7 und 8, wobei der mindestens eine Greifer und mindestens ein elektrischer Verbinder in derselben Richtung gegen die Leiterplatte (24) vorgespannt sind.

10. Verfahren nach Anspruch 9, bei dem der mindestens eine Greifer und mindestens eine elektrische Verbinder seitlich über die Leiterplatte vorgespannt sind.

11. Verfahren nach einem der vorhergehenden Ansprüche, wobei der Sensor zum Lesen einer Skala (6) geeignet ist, die eine Reihe von Markierungen umfasst und deren Ausgang zur Verwendung beim Bestimmen der relativen Position des Lesekopfs und einer Skala konfiguriert ist, wobei das Verfahren umfasst: Platzieren eines Kalibrierungsgegenstands (114), so dass der Sensor das Kalibrierungsgegenstand erfassen und den relativen Ort des Sensors und / oder einer optischen Komponente unter Verwendung des Ausgangs von dem Sensor optimieren kann.

12. Verfahren nach einem der vorhergehenden Ansprüche, bei dem der Sensor eine Anordnung von Photodetektoren zum Erfassen eines Interferenzstreifens umfasst.

13. Verfahren nach Anspruch 12, bei dem der Sensor zwei oder mehr Sätze von verschachtelten Photodetektoren umfasst, wobei jeder Satz konfiguriert ist, um eine andere Phase eines Interferenzstreifens zu erfassen.

## Revendications

1. Procédé (200) de fabrication d'un dispositif de mesure comprenant une tête de lecture (4) pour un appareil codeur de mesure de position optique, la tête de lecture comprenant au moins un capteur (36, 38), le capteur comprenant au moins un photodétecteur (36),
**caractérisé en ce que** le procédé comprend le fait :
de positionner au moins un composant (26) de la tête de lecture et l'au moins un capteur l'un par rapport à l'autre en utilisant la sortie de l'au moins un capteur, qui comprend le fait de modifier légèrement (208) l'emplacement relatif de l'au moins un capteur et de l'au moins un composant en utilisant la sortie du capteur, l'au moins un composant comprenant un composant optique, dans lequel le procédé comprend un appareil de fabrication (100) comprenant un actionneur (101) maintenant et déplaçant l'au moins un capteur et un dispositif de processeur (120) en utilisant la sortie du capteur pour commander le mouvement de l'actionneur de manière à positionner l'au moins un capteur.

2. Procédé tel que revendiqué dans la revendication 1, dans lequel l'au moins un composant comprend une lentille.

3. Procédé tel que revendiqué dans la revendication 1, dans lequel l'au moins un composant comprend un réseau de diffraction.

4. Procédé tel que revendiqué dans la revendication 1, l'appareil de fabrication comprenant au moins un connecteur électrique (108, 110, 112) pour la connexion électrique au capteur lorsqu'il est maintenu par l'actionneur.

5. Procédé tel que revendiqué dans la revendication 4, dans lequel l'actionneur comprend l'au moins un connecteur électrique.

6. Procédé tel que revendiqué dans la revendication 5, dans lequel l'actionneur comprend au moins une pince (102, 104, 106) pour venir en prise avec le composant.

7. Procédé tel que revendiqué dans les revendications 5 et 6, au moins l'une de ladite au moins une pince comprenant ledit au moins un connecteur électrique.

8. Procédé tel que revendiqué dans l'une des revendications précédentes, dans lequel le capteur est monté sur une carte de circuit imprimé ("PCB") (24).

9. Procédé tel que revendiqué dans les revendications 6, 7 et 8, dans lequel l'au moins une pince et l'au moins un connecteur électrique sont sollicités contre la PCB (24) dans la même direction.

10. Procédé tel que revendiqué dans la revendication 9, dans lequel l'au moins une pince et l'au moins un connecteur électrique sont sollicités latéralement à travers la PCB.

11. Procédé tel que revendiqué dans l'une des revendications précédentes, le capteur étant adapté pour lire une échelle (6) comprenant une série de graduations et dont la sortie est configurée pour être utilisée dans la détermination de la position relative de la tête de lecture et d'une échelle, le procédé comprenant, la mise en place d'un artéfact d'étalonnage (114) de sorte que le capteur puisse détecter l'artéfact d'étalonnage et modifier légèrement l'emplacement relatif du capteur et/ou d'un composant optique en utilisant la sortie du capteur.

12. Procédé tel que revendiqué dans l'une des revendications précédentes, dans lequel le capteur comprend une matrice de photodétecteurs pour détecter une frange d'interférence.

13. Procédé tel que revendiqué dans la revendication 12, dans lequel le capteur comprend deux ensembles ou plus de photodétecteurs interdigités, chaque ensemble étant configuré pour détecter une phase différente d'une frange d'interférence.
